# EUROPEAN PATENT APPLICATION

(11) **EP 4 674 635 A1**
(43) Date of publication of application: **07.01.2026**
(21) Application number: 24763586.5
(22) Date of filing: 13.02.2024
(51) Int. Cl.: B41N 1/00, B41C 1/00, G03F 7/00, G03F 7/027, G03F 7/075, G03F 7/095, G03F 7/11, G03F 7/20

(54) **FLEXOGRAPHIC PRINTING PLATE AND METHOD FOR MANUFACTURING SAME**

(30) Priority: 28.02.2023 JP 2023029858
(71) Applicant: FUJIFILM Corporation, Tokyo 106-8620 (JP)
(72) Inventor: SHIRAKAWA, Masato, Haibara-gun, Shizuoka 421-0396 (JP)
(74) Representative: HGF
(86) International application number: PCT/JP2024/004734
(87) International publication number: WO 2024/181102

(57) **Abstract**

An object of the present invention is to provide a flexographic printing plate having excellent printing durability and hardly causing ink picking, and a method for manufacturing the same. The flexographic printing plate of the present invention is a flexographic printing plate in which an image area satisfies a requirement C.

Requirement C: assuming that a shading of an image expressed by the image area is formed by halftone dots having a screen ruling α, in a case where a region of the image area corresponding to a region where a diameter of the halftone dots is less than 17 µm is defined as X, a region of the image area corresponding to a region where a diameter of the halftone dots is 17 µm or more and 45 µm or less is defined as Y, and a region of the image area corresponding to a region where a diameter of the halftone dots is more than 45 µm is defined as Z,
in X, the shading is formed by irregularly arranged halftone dots P having a diameter of 17 µm or more and 45 µm or less,
in Y, the shading is formed by irregularly arranged halftone dots P having a diameter of 17 µm or more and 45 µm or less, or by halftone dots Q having the screen ruling α, and
in Z, the shading is formed by halftone dots Q having the screen ruling α,
provided that a diameter of halftone dots Pmin having the smallest diameter is equal to or less than a diameter of the halftone dots Q.

## Description

### BACKGROUND OF THE INVENTION

### 1. Field of the Invention

The present invention relates to a flexographic printing plate and a method for manufacturing the same.

### 2. Description of the Related Art

In general, a flexographic printing plate is manufactured by exposing a flexographic printing plate precursor including, on a support, a photosensitive resin layer (photosensitive layer) consisting of a photosensitive resin composition to a predetermined image, and removing a resin in a non-exposed portion.

In a case where the flexographic printing plate precursor is a laser ablation mask (LAM), a heat-sensitive image forming layer (infrared ablation layer) is provided in advance on the photosensitive layer, and a desired negative pattern is produced by directly drawing digitized negative image information on the heat-sensitive image forming layer using an infrared laser. The production of the negative pattern is performed by, for example, an amplitude modulation (AM) screen of 175 line per inch (lpi) (JP2014-63132A).

### SUMMARY OF THE INVENTION

In a case where the present inventors manufacture a flexographic printing plate with reference to JP2014-63132A, it is found that highlight halftone dots (halftone dots having a density of approximately 10% or less) are likely to be chipped due to a pushing operation during printing or a plate washing operation performed regularly during the printing. That is, it is clarified that printing durability may be insufficient.

In addition, in recent years, there is also a demand for further reduction in ink picking in the flexographic printing plate.

Therefore, in consideration of the above-described circumstances, an object of the present invention is to provide a flexographic printing plate having excellent printing durability and hardly causing ink picking, and a method for manufacturing the same.

As a result of intensive studies on the above-described problems, the present inventors have found that the above-described problems can be solved as a diameter and arrangement of halftone dots in an image area satisfy a specific requirement, and have completed the present invention.

That is, the present inventors have found that the above-described objects are achieved by the following configurations.
(1) A flexographic printing plate comprising:
   an image area,
   in which the image area satisfies the following requirement C,
   the requirement C: assuming that a shading of an image expressed by the image area is formed by halftone dots having a screen ruling α, in a case where a region of the image area corresponding to a region X' where a diameter of the halftone dots is less than 17 µm is defined as a region X, a region of the image area corresponding to a region Y' where a diameter of the halftone dots is 17 µm or more and 45 µm or less is defined as a region Y, and a region of the image area corresponding to a region Z' where a diameter of the halftone dots is more than 45 µm is defined as a region Z,
   in the region X, the shading is formed by irregularly arranged halftone dots P having a diameter of 17 µm or more and 45 µm or less,
   in the region Y, the shading is formed by irregularly arranged halftone dots P having a diameter of 17 µm or more and 45 µm or less, or by halftone dots Q having the screen ruling α, and
   in the region Z, the shading is formed by halftone dots Q having the screen ruling α,
   provided that, among the halftone dots P, a diameter of halftone dots Pmin having a smallest diameter is equal to or less than a diameter of the halftone dots Q.
(2) The flexographic printing plate according to (1),
   in which the flexographic printing plate is obtained from a flexographic printing plate precursor including a support and a photosensitive layer in this order,
   the photosensitive layer contains at least a binder, a (meth)acrylate having a molecular weight of 600 or less, a photopolymerization initiator, and a polymerization inhibitor, and
   the following requirements A-1 and B-1 are satisfied,
   the requirement A-1: in a case where a concentration of a (meth)acryloyl group of the (meth)acrylate in the photosensitive layer is denoted by M, 0.4 ≤ M ≤ 2.0 is satisfied, in which a unit of the concentration is mol/kg,
   the requirement B-1: in a case where a concentration of the photopolymerization initiator in the photosensitive layer is denoted by I and a concentration of the polymerization inhibitor in the photosensitive layer is denoted by K, 0.5 ≤ I/K ≤ 200 is satisfied, in which a unit of the concentration is mol/kg.
(3) The flexographic printing plate according to (1) or (2),
   in which a microhardness of the halftone dots P is 1.5 MPa or more and 30 MPa or less.
(4) The flexographic printing plate according to (2),
   in which the photosensitive layer satisfies the following requirement A-2,
   the requirement A-2: 0.65 ≤ M ≤ 1.0 is satisfied.
(5) The flexographic printing plate according to (2) or (4),
   in which the photosensitive layer satisfies the following requirement B-2,
   the requirement B-2: 5 ≤ I/K ≤ 100 is satisfied.
(6) The flexographic printing plate according to any one of (2), (4), and (5),
   in which the photosensitive layer contains two or more kinds of (meth)acrylates.
(7) The flexographic printing plate according to any one of (2) and (4) to (6),
   in which the photosensitive layer further contains a silicone compound.
(8) The flexographic printing plate according to any one of (2) and (4) to (7),
   in which the flexographic printing plate precursor further includes a heat-sensitive image forming layer, and the support, the photosensitive layer, and the heat-sensitive image forming layer are provided in this order, and
   the flexographic printing plate precursor further includes an oxygen barrier layer between the photosensitive layer and the heat-sensitive image forming layer.
(9) A method for manufacturing a flexographic printing plate, in which the flexographic printing plate is the flexographic printing plate according to any one of (1) to (8), and is obtained from a flexographic printing plate precursor including a support, a photosensitive layer, and a heat-sensitive image forming layer in this order, the method comprising:
   a mask forming step of forming an image on the heat-sensitive image forming layer to form a mask such that the image area satisfies the requirement C, in which, on the heat-sensitive image forming layer, the image is formed by an FM screen in a region corresponding to the region of the halftone dots P and is formed by an AM screen in a region corresponding to the region of the halftone dots Q;
   an exposure step of imagewise exposing the photosensitive layer of the flexographic printing plate precursor through the mask after the mask forming step; and
   a development step of, after the exposure step, performing development using a developer to form the image area.
(10) The method for manufacturing a flexographic printing plate according to (9),
   in which the exposure step is a step of performing the exposure using an LED-UV as a light source.

As described below, according to the present invention, it is possible to provide a flexographic printing plate having excellent printing durability and hardly causing ink picking, and a method for manufacturing the same.

### BRIEF DESCRIPTION OF THE DRAWINGS

Fig. 1 is a schematic view in a case where a shading is formed by halftone dots having a screen ruling α, for an example of a gradation image.
Fig. 2 is a schematic view of an aspect of an image area of a printing plate according to the embodiment of the present invention.

### DESCRIPTION OF THE PREFERRED EMBODIMENTS

Hereinafter, the present invention will be described in detail.

The description of configuration requirements described below may be made on the basis of representative embodiments of the present invention, but it should not be construed that the present invention is limited to those embodiments.

In the present specification, the numerical range expressed by using "to" means a range including the numerical values before and after "to" as the lower limit value and the upper limit value.

In addition, each component may be used alone or in combination of two or more thereof. Here, in a case where two or more kinds are used in combination for each component, a content with regard to the component indicates the total content thereof, unless otherwise specified.

In addition, "(meth)acryl" represents a notation of "acryl" or "methacryl", "(meth)acrylate" represents a notation of "acrylate" or "methacrylate", and "(meth)acryloyl" represents a notation of "acryloyl" or "methacryloyl".

In addition, "solid content" refers to a component other than a volatile component such as a solvent.

In addition, "screen ruling" refers to line per inch (lpi; number of lines per inch).

In addition, in a case where halftone dots partially overlap each other, each of the halftone dots is also referred to as a halftone dot, and a diameter of the halftone dot in this case is based on a non-overlapping portion (circumference).

In addition, the fact that ink picking is unlikely to occur is also referred to as "excellent in ink picking".

In addition, the fact that printing durability and ink picking are excellent is also referred to as "effects of the present invention are excellent".

In addition, regarding a flexographic printing plate precursor, the fact that a flexographic printing plate to be obtained has excellent effects of the present invention is also simply referred to as "effects of the present invention are excellent".

In addition, an image area and a non-image area are collectively referred to as "image area and the like".

### [1] Flexographic printing plate

The flexographic printing plate according to the embodiment of the present invention (hereinafter, also referred to as "printing plate according to the embodiment of the present invention") is a flexographic printing plate having an image area, in which the image area satisfies the following requirement C.

Requirement C: assuming that a shading of an image expressed by the image area is formed by halftone dots having a screen ruling α, in a case where a region of the image area corresponding to a region X' where a diameter of the halftone dots is less than 17 µm is defined as a region X, a region of the image area corresponding to a region Y' where a diameter of the halftone dots is 17 µm or more and 45 µm or less is defined as a region Y, and a region of the image area corresponding to a region Z' where a diameter of the halftone dots is more than 45 µm is defined as a region Z,
in the region X, the shading is formed by irregularly arranged halftone dots P having a diameter of 17 µm or more and 45 µm or less,
in the region Y, the shading is formed by irregularly arranged halftone dots P having a diameter of 17 µm or more and 45 µm or less, or by halftone dots Q having the screen ruling α, and
in the region Z, the shading is formed by halftone dots Q having the screen ruling α,
provided that, among the halftone dots P, a diameter of halftone dots Pmin having the smallest diameter is equal to or less than a diameter of the halftone dots Q.

Since the printing plate according to the embodiment of the present invention has such a configuration, it is considered that the above-described problems are solved. That is, since the shading is formed by the halftone dots P which are irregularly arranged in the region X and have a diameter of 17 µm or more and 45 µm or less, it is considered that the diameter of the halftone dots is not excessively small, and this point leads to excellent printing durability. In addition, since the halftone dots Q having the screen ruling α are regularly and evenly arranged in the region Y2 and the region Z, it is considered that the halftone dots do not come too close to each other in a case where a certain density is exhibited, and this point leads to an excellent ink picking suppression effect.

First, one aspect of the printing plate according to the embodiment of the present invention will be described with reference to the drawing.

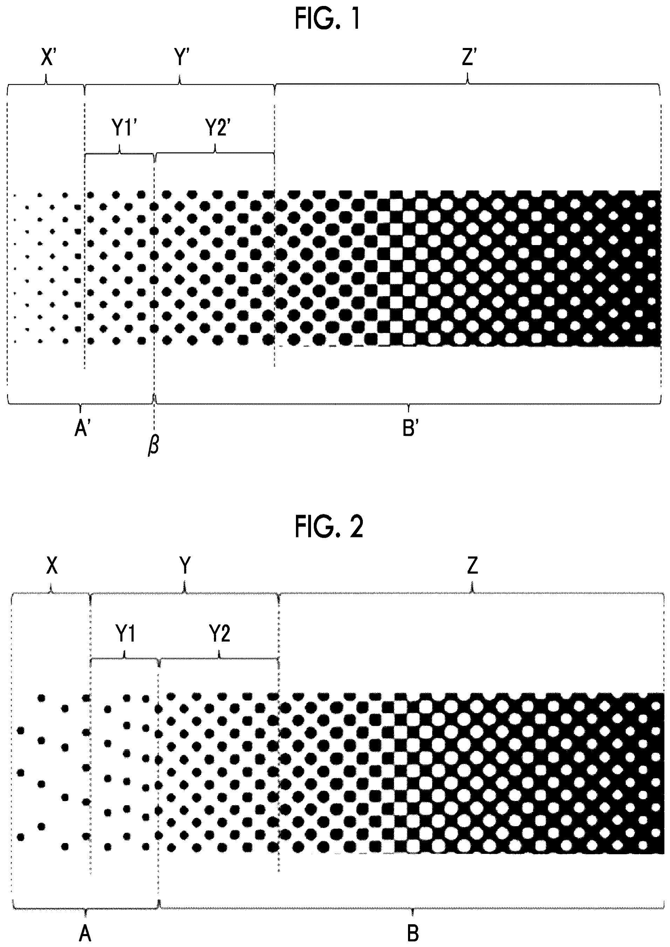

Fig. 1 is a schematic view in a case where a shading is formed by halftone dots having the screen ruling α (for example, screen ruling of 175), for an example of a gradation image (hereinafter, also simply referred to as an "image example") expressed by the image area of the printing plate according to the embodiment of the present invention. The halftone dots are regularly arranged. A diameter of the halftone dots is larger on the right side of the thick side, and smaller on the left side of the thin side.

In Fig. 1, a region X' is a region where the diameter of the halftone dots is less than 17 µm, a region Y' is a region where the diameter of the halftone dots is 17 µm or more and 45 µm or less, and a region Z' is a region where the diameter of the halftone dots is more than 45 µm.

Fig. 2 is a schematic view of one aspect of the image area in a case where the image area of the printing plate according to the embodiment of the present invention expresses the above-described image example.

In the image area of Fig. 2, a shading is formed by the halftone dots P which are irregularly arranged in a region X corresponding to the region X', and have an substantially constant diameter of 17 µm or more and 45 µm or less (for example, 25 µm).

In addition, in the region Y', a shading is formed by the halftone dots P which are irregularly arranged in a region Y1 corresponding to the region Y1' having a smaller diameter of the halftone dots (for example, a region where the diameter of the halftone dots is 17 µm or more and less than 25 µm), and have an substantially constant diameter of 17 µm or more and 45 µm or less (for example, 25 µm).

In addition, in the region Y', a shading is formed by the halftone dots Q having the screen ruling α in a region Y2 corresponding to the region Y2' having a larger diameter of the halftone dots (for example, a region where the diameter of the halftone dots is 25 µm or more and 45 µm or less).

In addition, a shading is formed by the halftone dots Q having the screen ruling α in a region Z corresponding to the region Z'.

Here, among the halftone dots P, the diameter of the halftone dots Pmin having the smallest diameter (for example, 25 µm) is equal to or less than the diameter of the halftone dots Q (for example, 25 µm or more).

In addition, the following is considered as another viewpoint.

In Fig. 1, a diameter of halftone dots as a boundary between the region Y1' and the region Y2' is defined as β (for example, 25 µm), a region where the diameter of the halftone dots is less than β is denoted by a region A' (region consisting of the region X' and the region Y1'), and a region where the diameter of the halftone dots is equal to or more than β is denoted by a region B' (region consisting of the region Y2' and the region Z'). In this case, the following is satisfied.

In the image area of Fig. 2, a shading is formed by the halftone dots P (for example, 25 µm) in a region A corresponding to the region A'.

In addition, a shading is formed by the halftone dots Q having the screen ruling a in a region B corresponding to the region B'.

Here, among the halftone dots P, the diameter of the halftone dots Pmin having the smallest diameter (for example, 25 µm) is equal to or less than the diameter of the halftone dots Q (for example, 25 µm or more).

With regard to the image area of Fig. 2, in the region X, the shading is formed by the halftone dots P which are irregularly arranged and have a diameter of 17 µm or more and 45 µm or less; in the region Y (the region Y1 and the region Y2), the shading is formed by the halftone dots P which are irregularly arranged and have a diameter of 17 µm or more and 45 µm or less or by the halftone dots Q having the screen ruling a; and in the region Z, the shading is formed by the halftone dots Q having the screen ruling α.

In addition, among the halftone dots P, the diameter of the halftone dots Pmin having the smallest diameter is equal to or less than the diameter of the halftone dots Q.

Therefore, the image area of Fig. 2 satisfies the above-described requirement C.

### [Requirement C]

### [Screen ruling α]

From the reason that the effects of the present invention are more excellent, the screen ruling α in the requirement C is preferably 50 or more, more preferably 100 or more, and particularly preferably 150 or more.

### [Halftone dots P]

The halftone dots P are irregularly arranged halftone dots having a (preferably constant) diameter of 17 µm or more and 45 µm or less. The halftone dots P are halftone dots which form a shading depending on the density of the halftone dots.

### <Diameter>

From the reason that the effects of the present invention are more excellent, the diameter of the halftone dots P is preferably 20 µm or more and 30 µm or less.

The diameter of the halftone dots P may vary as long as it is in the range of 17 µm or more and 45 µm or less, but from the reason that the effects of the present invention are more excellent, the variation in diameter is preferably ±10% or less and more preferably ±5% or less.

### <Microhardness>

From the reason that the effects of the present invention are more excellent, a microhardness of the halftone dots P is preferably 1.5 MPa or more and 30 MPa or less, more preferably 2.5 MPa or more and 25 MPa or less, and still more preferably 5.0 MPa or more and 20 MPa or less.

The microhardness can be measured with Fischer Scope HM2000XyP (manufactured by FISCHER instruments).

The image area of the produced printing plate is cut out to a size of approximately 3 cm square, fixed to a slide glass with an adhesive such that the image area faces upward, and a hardness in a case where the measurement detector is pushed from the upper part and pushed in by 10 µm is defined as the microhardness of the halftone dots P. A Vickers indenter is used as an indenter.

Examples of the method of setting the microhardness within the above-described range include a method of using, as the flexographic printing plate precursor, a flexographic printing plate precursor including a photosensitive layer satisfying a requirement A-1 and a requirement B-1, which will be described later.

### [Halftone dots Q]

The halftone dots Q are halftone dots having the screen ruling α (halftone dots regularly arranged).

The halftone dots Q are halftone dots which form a shading depending on the size (diameter) of the halftone dots.

Since the halftone dots Q do not form the region X, the diameter of the halftone dots Q is 17 µm or more. From the reason that the effects of the present invention are more excellent, the diameter of the halftone dots Q is preferably 20 µm or more.

### [β]

The above-described β (the boundary between the region A' and the region B') is not particularly limited as long as it is 17 µm or more and 45 µm or less, but from the reason that the effects of the present invention are more excellent, it is preferably 20 µm or more and 30 µm or less.

### [Non-image area]

The printing plate according to the embodiment of the present invention may have a non-image area.

### [Suitable aspect]

From the reason that the effects of the present invention are more excellent, the printing plate according to the embodiment of the present invention is preferably obtained from a flexographic printing plate precursor including a support and a photosensitive layer in this order, more preferably obtained by the manufacturing method according to the embodiment of the present invention, which will be described later, and more preferably obtained by a suitable aspect of the manufacturing method according to the embodiment of the present invention, which will be described later.

Specific examples and suitable aspects of the support and the photosensitive layer are as described later.

### [2] Method for manufacturing flexographic printing plate

A method for manufacturing the printing plate according to the embodiment of the present invention is not particularly limited, but from the reason that the effects of the present invention are more excellent, it is preferable to be a method for manufacturing a flexographic printing plate (hereinafter, also referred to as "manufacturing method according to the embodiment of the present invention"), in which the flexographic printing plate is the printing plate according to the embodiment of the present invention, and is obtained from a flexographic printing plate precursor including a support, a photosensitive layer, and a heat-sensitive image forming layer in this order, the method including:
a mask forming step of forming an image on the heat-sensitive image forming layer to form a mask such that the image area satisfies the above-described requirement C, in which, on the heat-sensitive image forming layer, the image is formed by an FM screen in a region corresponding to the region of the halftone dots P described above and is formed by an AM screen in a region corresponding to the region of the halftone dots Q described above;
an exposure step of imagewise exposing the photosensitive layer of the flexographic printing plate precursor through the mask after the mask forming step; and
a development step of, after the exposure step, performing development using a developer to form the image area.

First, the flexographic printing plate precursor will be described, and then each step will be described.

### [Flexographic printing plate precursor]

The flexographic printing plate precursor includes a support, a photosensitive layer, and a heat-sensitive image forming layer in this order.

Hereinafter, each layer of the flexographic printing plate precursor will be described.

### [Support]

A material used for the support is not particularly limited, and a support with high dimensional stability is preferably used. Examples thereof include metals such as steel, stainless steel, and aluminum; polyester (for example, polyethylene terephthalate (PET), polybutylene terephthalate (PBT), polyethylene naphthalate (PEN), polyimide (PI), polyamide, liquid crystal polymer (LCP), and polyacrylonitrile (PAN)); plastic resins such as polyvinyl chloride; synthetic rubber such as styrene-butadiene rubber; glass fiber reinforced plastic resin (such as epoxy resin and phenolic resin); and cloth and paper.

From the viewpoint of dimensional stability and availability, the support is preferably a polymer film or cloth, and more preferably a polymer film. The morphology of the support is determined by whether the polymer layer is sheet-like or sleeve-like.

As the cloth, plain or twill weave fabrics and various knitted fabrics of natural fibers such as cotton, linen, silk, and wool or synthetic fibers such as acetate, vinylon, vinylidene, polyvinyl chloride, acrylic, polypropylene, polyethylene, polyurethane, fluorine filament, polyclar, rayon, nylon, polyamide, and polyester, or nonwoven fabrics can be used.

Examples of the polymer film include a film formed of various polymers such as polyester (for example, polyethylene terephthalate (PET), polybutylene terephthalate (PBT), polyethylene naphthalate (PEN), polyimide (PI), polyamide, liquid crystal polymer (LCP), and polyacrylonitrile (PAN)); plastic resins such as polyvinyl chloride; synthetic rubber such as styrene-butadiene rubber; and glass fiber reinforced plastic resin (such as epoxy resin and phenolic resin). Among these, from the viewpoint of dimensional stability and the like, a polyester film is preferable.

Examples of the above-described polyester film include a PET film, a PBT film, and a PEN film, and from the viewpoint of dimensional stability and the like, a polyethylene terephthalate (PET) film is preferable.

A thickness of the support is not particularly limited, but from the viewpoint of dimensional stability and handleability, it is preferably 5 to 3,000 µm, more preferably 50 to 2,000 µm, and still more preferably 100 to 1,000 µm.

### [Photosensitive resin layer]

The photosensitive resin layer (photosensitive layer) is not particularly limited, and can be formed of a known photosensitive resin composition in the related art.

The photosensitive resin layer contains, for example, water-dispersible particles, a liquid polymer, a binder, a (meth)acrylate, a photopolymerization initiator, a plasticizer, a surfactant, a polymerization inhibitor, and the like.

### <Water-dispersible particles>

From the reason that the effects of the present invention are more excellent, the photosensitive resin layer preferably contains water-dispersible particles.

The water-dispersible particles are not particularly limited, but from the reason that the effects of the present invention are more excellent, a polymer is preferable.

Specific examples of the above-described polymer include diene-based polymers (for example, polybutadiene, natural rubber, styrene-butadiene copolymer, acrylonitrile-butadiene copolymer, methyl methacrylate-butadiene copolymer, polychloroprene, and polyisoprene), polyurethane, vinylpyridine polymer, butyl polymer, thiokol polymer, acrylate polymer, and a polymer obtained by copolymerizing these polymers with other components such as acrylic acid and methacrylic acid. These may be used alone or in combination of two or more.

From the reason that the effects of the present invention are more excellent, the above-described polymer is preferably a diene-based polymer and more preferably polybutadiene.

From the reason that the effects of the present invention are more excellent, it is preferable that the above-described polymer does not have a reactive functional group (for example, a (meth)acryloyloxy group) at both terminals.

From the reason that the effects of the present invention are more excellent, it is preferable that the above-described polymer is a polymer obtained by removing water from water-dispersible latex. Specific examples of the above-described water-dispersible latex include water-dispersible latex of specific examples of the above-described polymer.

### (Content)

In the photosensitive resin layer, from the reason that the effects of the present invention are more excellent, a content of the water-dispersible particles is preferably 5% to 80% by mass, more preferably 10% to 50% by mass, and still more preferably 20% to 40% by mass with respect to the total solid content of the photosensitive resin layer.

### <Liquid polymer>

From the reason that the effects of the present invention are more excellent, the photosensitive resin layer preferably contains a liquid polymer.

From the reason that the effects of the present invention are more excellent, it is preferable that the liquid polymer has a reactive functional group at both terminals.

### (Main chain)

A polymer constituting a main chain of the liquid polymer is not particularly limited, and examples thereof include a thermoplastic polymer.

The thermoplastic polymer is not particularly limited as long as the thermoplastic polymer is a polymer exhibiting thermoplasticity, and specific examples thereof include a polystyrene resin, a polyester resin, a polyamide resin, a polysulfone resin, a polyethersulfone resin, a polyimide resin, an acrylic resin, an acetal resin, an epoxy resin, a polycarbonate resin, rubbers, and a thermoplastic elastomer.

Among these, from the reason that more elastic and flexible film can be easily formed, a rubber or a thermoplastic elastomer is preferable, a rubber is more preferable, and a diene-based rubber is still more preferable.

Specific examples of the above-described rubber include butadiene rubber (BR), nitrile rubber (NBR), acrylic rubber, epichlorohydrin rubber, urethane rubber, isoprene rubber, styrene isoprene rubber, styrene butadiene rubber, ethylene-propylene copolymer, and chlorinated polyethylene. These may be used alone or in combination of two or more. Among these, from the reason that the water developability is improved, or from the viewpoint of drying properties and image reproducibility, at least one rubber selected from the group consisting of butadiene rubber (BR) and nitrile rubber (NBR) is preferable, and butadiene rubber is more preferable.

Examples of the above-described thermoplastic elastomer include a polybutadiene-based thermoplastic elastomer, a polyisoprene-based thermoplastic elastomer, a polyolefin-based thermoplastic elastomer, and an acrylic thermoplastic elastomer. Specific examples thereof include polystyrene-polybutadiene (SB), polystyrene-polybutadiene-polystyrene (SBS), polystyrene-polyisoprene-polystyrene (SIS), polystyrene-polyethylene/polybutylene-polystyrene (SEBS), acrylonitrile butadiene styrene copolymer (ABS), acrylic acid ester rubber (ACM), acrylonitrile-chlorinated polyethylene-styrene copolymer (ACS), acrylonitrile-styrene copolymer, syndiotactic 1,2-polybutadiene, and methyl polymethacrylate-butyl polyacrylate-methyl polymethacrylate. Among these, from the reason that water developability is improved, or from the viewpoint of drying properties and image reproducibility, SBS or SIS is particularly preferable.

### (Terminal)

As described above, from the reason that the effects of the present invention are more excellent, it is preferable that the liquid polymer has a reactive functional group at both terminals.

The above-described reactive functional group is not particularly limited, but from the reason that the effects of the present invention are more excellent, an ethylenically unsaturated group is preferable.

From the reason that the effects of the present invention are more excellent, the above-described ethylenically unsaturated group is preferably a vinyl group (CH₂=CH-), an allyl group (CH₂=CH-CH₂-), a (meth)acryloyl group, or a (meth)acryloyl group, and more preferably a (meth)acryloyloxy group.

The liquid polymer may have a reactive functional group at both terminals of the polymer constituting the main chain through a divalent linking group.

The above-described divalent linking group is not particularly limited, and examples thereof include a linear, branched, or cyclic divalent aliphatic hydrocarbon group (for example, an alkylene group such as a methylene group, an ethylene group, and a propylene group), a divalent aromatic hydrocarbon group (for example, a phenylene group), -O-, -S-, -SO₂-, -NR_{L}-, -CO-, -NH-, -COO-, -CONR_{L}-, -O-CO-O-, -SO₃-, -NHCOO-, -SO₂NR_{L}-, -NH-CO-NH-, and a group in which two or more of these groups are combined (for example, an alkyleneoxy group, an alkyleneoxycarbonyl group, an alkylenecarbonyloxy group, and the like). Here, R_{L} represents a hydrogen atom or an alkyl group (preferably having 1 to 10 carbon atoms).

### (Molecular weight)

From the reason that the effects of the present invention are more excellent, a weight-average molecular weight (Mw) of the liquid polymer is preferably 1,000 or more and less than 100,000, and more preferably 5,000 to 50,000.

In the specification of the present application, the weight-average molecular weight (Mw) and number-average molecular weight (Mn) are measured by a gel permeation chromatography method (GPC), and are obtained by converting with standard polystyrene. Specifically, for example, HLC-8220 GPC (manufactured by Tosoh Corporation) is used as GPC, three of TSKgeL SuperHZM-H, TSKgeL SuperHZ4000, and TSKgeL SuperHZ2000 (all manufactured by Tosoh Corporation, 4.6 mmID × 15 cm) are used as a column, and tetrahydrofuran (THF) is used as an eluent. In addition, as the conditions, a sample concentration of 0.35% by mass, a flow rate of 0.35 mL/minute (min), a sample injection amount of 10 µL, and a measurement temperature of 40°C are set, and an IR detector is used. In addition, a calibration curve is created using 8 samples of "F-40", "F-20", "F-4", "F-1", "A-5000", "A-2500", "A-1000", and "n-propylbenzene" which are "Standard Samples TSK standard, polystyrene" (manufactured by TOSOH Corporation).

### (Content)

In the photosensitive resin layer, from the reason that the effects of the present invention are more excellent, a content of the above-described liquid polymer is preferably 1% to 30% by mass, more preferably 3% to 20% by mass, and still more preferably 5% to 10% by mass with respect to the total solid content of the photosensitive resin layer.

### <Binder>

The binder is not particularly limited, and examples thereof include a thermoplastic polymer.

The thermoplastic polymer is not particularly limited as long as the thermoplastic polymer is a polymer exhibiting thermoplasticity, and specific examples thereof include a polystyrene resin, a polyester resin, a polyamide resin, a polysulfone resin, a polyethersulfone resin, a polyimide resin, an acrylic resin, an acetal resin, an epoxy resin, a polycarbonate resin, rubbers, and a thermoplastic elastomer. These may be used alone or in combination of two or more.

Among these, from the reason that elastic and flexible film can be easily formed, a rubber or a thermoplastic elastomer is preferable, a rubber is more preferable, and a diene-based rubber is still more preferable.

As the above-described rubber, in order to secure elasticity of the flexographic plate, a non-fluid rubber which does not have fluidity is preferable.

Specific examples thereof include butadiene rubber (BR), nitrile rubber (NBR), acrylic rubber, epichlorohydrin rubber, urethane rubber, isoprene rubber, styrene isoprene rubber, styrene butadiene rubber (SBR), ethylene-propylene copolymer, and chlorinated polyethylene. These may be used alone or in combination of two or more. Among these, from the reason that water developability is improved, or from the viewpoint of drying properties and image reproducibility, at least one rubber selected from the group consisting of butadiene rubber (BR), styrene butadiene rubber (SBR), and nitrile rubber (NBR) is preferable, and from the viewpoint of water-based ink resistance, butadiene rubber or styrene butadiene rubber is more preferable.

Examples of the above-described thermoplastic elastomer include a polybutadiene-based thermoplastic elastomer (PB), a polyisoprene-based thermoplastic elastomer, a polyolefin-based thermoplastic elastomer, and an acrylic thermoplastic elastomer. Specific examples thereof include polystyrene-polybutadiene (SB), polystyrene-polybutadiene-polystyrene (SBS), polystyrene-polyisoprene-polystyrene (SIS), polystyrene-polyethylene/polybutylene-polystyrene (SEBS), acrylonitrile butadiene styrene copolymer (ABS), acrylic acid ester rubber (ACM), acrylonitrile-chlorinated polyethylene-styrene copolymer (ACS), acrylonitrile-styrene copolymer, syndiotactic 1,2-polybutadiene, and methyl polymethacrylate-butyl polyacrylate-methyl polymethacrylate. Among these, from the reason that water developability is improved, or from the viewpoint of drying properties and image reproducibility, PB, SBS, or SIS is particularly preferable.

### (Molecular weight)

A weight-average molecular weight (Mw) of the binder is not particularly limited, but from the reason that the effects of the present invention are more excellent, it is preferably 100,000 or more, more preferably 200,000 or more, still more preferably 300,000 to 2,000,000, particularly preferably 300,000 to 1,500,000, and most preferably 300,000 to 700,000.

### (Content)

In the photosensitive resin layer, from the reason that the effects of the present invention are more excellent, a content of the binder is preferably 1% to 50% by mass, more preferably 5% to 40% by mass, and still more preferably 7% to 30% by mass with respect to the total solid content of the photosensitive resin layer.

### <(Meth)acrylate>

The (meth)acrylate is a compound having a (meth)acryloyl group.

Suitable examples of the (meth)acrylate include a compound having 2 to 20 (meth)acryloyl groups, and specific examples thereof include alkanediol (meth)acrylate compounds such as 1,3-butanediol dimethacrylate, 1,4-butanediol diacrylate, 1,4-butanediol dimethacrylate, 1,6-hexanediol diacrylate, 1,6-hexanediol dimethacrylate, 1,9-nonanediol diacrylate, 1,9-nonanediol dimethacrylate, 1,12-dodecanediol diacrylate, 1,12-dodecanediol dimethacrylate, tricyclodecane dimethanol dimethacrylate, and tricyclodecane dimethanol diacrylate;
glycol di(meth)acrylate compounds such as ethyleneglycol di(meth)acrylate, diethyleneglycol di(meth)acrylate, triethyleneglycol di(meth)acrylate, tetraethyleneglycol di(meth)acrylate, polyethyleneglycol di(meth)acrylate, propyleneglycol di(meth)acrylate, dipropyleneglycol di(meth)acrylate, tripropyleneglycol di(meth)acrylate, tetrapropyleneglycol di(meth)acrylate, polypropyleneglycol di(meth)acrylate, ethoxylated neopentylglycol di(meth)acrylate, and propoxylated neopentylglycol di(meth)acrylate;
di(meth)acrylate compounds of bisphenol A, such as bisphenol A diglycidyl ether (meth)acrylic acid adduct, modified bisphenol A di(meth)acrylate, bisphenol A PO-adducted di(meth)acrylate, and bisphenol A EO-adducted di(meth)acrylate;
tri- or higher valent ester compounds of alcohol, such as pentaerythritol tri(meth)acrylate, pentaerythritol tetra(meth)acrylate, dipentaerythritol tetra(meth)acrylate, trimethylolethane tri(meth)acrylate, trimethylolpropane tri(meth)acrylate, and tetramethylolmethane tetra(meth)acrylate; and
bis(4-(meth)acryloxypolyethoxyphenyl)propane.
PO represents propylene oxide and EO represents ethylene oxide.

### (Suitable aspect)

From the reason that the effects of the present invention are more excellent, the photosensitive resin layer preferably contains two or more kinds of (meth)acrylates.

### (Molecular weight)

From the reason that the effects of the present invention are more excellent, a molecular weight of the (meth)acrylate is preferably 100 or more and less than 1,000, and more preferably 200 or more and 600 or less.

### (Content)

In the photosensitive resin layer, from the reason that the effects of the present invention are more excellent, a content of the (meth)acrylate is preferably 1% to 30% by mass, more preferably 2% to 25% by mass, and still more preferably 5% to 20% by mass with respect to the total solid content of the photosensitive resin layer.

### <Photopolymerization initiator>

The photopolymerization initiator is not particularly limited, and examples thereof include photopolymerization initiators such as alkylphenones, acetophenones, benzoin ethers, benzophenones, thioxanthones, anthraquinones, benzyls, and biacetyls.

More specific examples thereof include benzyl dimethyl ketal, 2-hydroxy-2-methyl-1-phenyl-propan-1-one, methyl-o-benzoylbenzoate, and 1-hydroxycyclohexyl phenyl ketone.

### (Content)

In the photosensitive resin layer, from the reason that the effects of the present invention are more excellent, a content of the photopolymerization initiator is preferably 0.3% to 15% by mass and more preferably 0.5% to 10% by mass with respect to the total solid content of the photosensitive resin layer.

### <Plasticizer>

From the reason that the effects of the present invention are more excellent, the photosensitive resin layer preferably contains a plasticizer.

Specific examples of the plasticizer include liquid rubber, oil, polyester, and phosphoric acid-based compounds.

Specific examples of the liquid rubber include liquid polybutadiene, liquid polyisoprene, and compounds in which these compounds are modified with maleic acid or an epoxy group.

Specific examples of the oil include paraffin, naphthene, and aroma.

Specific examples of the polyester include adipic acid-based polyester.

Specific examples of the phosphoric acid-based compound include phosphoric acid ester.

### (Content)

In the photosensitive resin layer, from the reason that the effects of the present invention are more excellent, a content of the plasticizer is preferably 0.1% to 40% by mass and more preferably 5% to 30% by mass with respect to the total solid content of the photosensitive resin layer.

### <Surfactant>

From the reason that the effects of the present invention are more excellent, the photosensitive resin layer preferably contains a surfactant.

Examples of the surfactant include a cationic surfactant, an anionic surfactant, and a nonionic surfactant. Among these, from the reason that the effects of the present invention are more excellent, an anionic surfactant is preferable.

Specific examples of the above-described anionic surfactant include
aliphatic carboxylates such as sodium laurate and sodium oleate;
higher alcohol sulfate salts such as sodium lauryl sulfate, sodium cetyl sulfate, and sodium oleyl sulfate;
polyoxyethylene alkyl ether sulfate ester salts such as sodium polyoxyethylene lauryl ether sulfate;
polyoxyethylene alkyl allyl ether sulfate ester salts such as sodium polyoxyethylene octyl phenyl ether sulfate and sodium polyoxyethylene nonyl phenyl ether sulfate;
alkyl sulfonates such as alkyl diphenyl ether disulfonate, sodium dodecyl sulfonate, and sodium dialkyl sulfosuccinate;
alkyl allyl sulfonates such as alkyl disulfonate, sodium dodecyl benzene sulfonate, sodium dibutyl naphthalene sulfonate, and sodium triisopropyl naphthalene sulfonate;
higher alcohol phosphate ester salts such as disodium lauryl phosphate monoester, and sodium lauryl phosphate diester; and
polyoxyethylene alkyl ether phosphate ester salts such as disodium polyoxyethylene lauryl ether phosphate monoester, and sodium polyoxyethylene lauryl ether phosphate diester.

These may be used alone or in combination of two or more.

Among these, from the reason that the effects of the present invention are more excellent, a sulfonic acid-based surfactant such as an alkyl sulfonate or an alkyl allyl sulfonate is preferable.

### (Content)

In the photosensitive resin layer, from the reason that the effects of the present invention are more excellent, a content of the surfactant is preferably 0.1% to 20% by mass and more preferably 1% to 10% by mass with respect to the total solid content of the photosensitive resin layer.

### <Polymerization inhibitor>

From the reason that the effects of the present invention are more excellent, the photosensitive resin layer preferably contains a polymerization inhibitor (thermal polymerization inhibitor).

Examples of the polymerization inhibitor include phenols, hydroquinones, and catechols. Among these, from the reason that the effects of the present invention are more excellent, phenols (particularly, dibutylhydroxytoluene (BHT)) are preferable.

### (Content)

In the photosensitive resin layer, from the reason that the effects of the present invention are more excellent, a content of the polymerization inhibitor is preferably 0.001% to 5% by mass with respect to the total solid content of the photosensitive resin layer.

### <Silicone compound>

From the reason that the effects of the present invention are more excellent, the photosensitive resin layer preferably contains a silicone compound.

Examples of the silicone compound include a silicone oil including a siloxane unit, a silane coupling agent, a silane compound, a silicone rubber, and a silicone resin.

From the reason that the effects of the present invention are more excellent, the silicone compound is preferably a compound having, in the main chain, a polyalkylsiloxane such as polydimethylsiloxane and polydiethylsiloxane. In addition, the silicone compound may be a compound having a polysiloxane structure in a part of the molecule. Furthermore, a compound in which a specific organic group is introduced into a polysiloxane structure can be used. Specifically, a compound in which an organic group is introduced into a side chain of polysiloxane, a compound in which an organic group is introduced into both terminals of polysiloxane, a compound in which an organic group is introduced into one terminal of polysiloxane, a compound in which an organic group is introduced into both a side chain and a terminal of polysiloxane, or the like can be used.

Specific examples of the organic group to be introduced into the polysiloxane structure include an amino group, a carboxyl group, a carbinol group, an aryl group, an alkyl group, an alkoxycarbonyl group, an alkoxy group, a linear or branched alkyl group substituted with at least one aryl group, and a polyoxyalkylene group (hereinafter, also referred to as "polyether group").

Among the above-described organic groups, from the reason that the effects of the present invention are more excellent, an amino group, a polyether group, or a carbinol group is preferable.

From the reason that the effects of the present invention are more excellent, the silicone compound is preferably a silicone modified with one or more selected from the group consisting of amine, polyether, and carbinol.

From the reason that the effects of the present invention are more excellent, the silicone compound is more preferably a silicone oil having a polysiloxane as a main skeleton and having, at at least one terminal, one or more groups selected from the group consisting of an amino group, a polyether group, and a carbinol group.

### (Molecular weight)

A number-average molecular weight (Mn) of the silicone compound is not particularly limited, but from the reason that the effects of the present invention are more excellent, it is preferably 100 to 15,000, more preferably 500 to 10,000, and still more preferably 1,000 to 3,000.

### (Content)

In the photosensitive resin layer, from the reason that the effects of the present invention are more excellent, a content of the silicone compound is preferably 0.001% to 5.0% by mass, more preferably 0.01% to 3.0% by mass, and still more preferably 0.1% to 2.0% by mass with respect to the total solid content of the photosensitive resin layer.

### <Other components>

To the extent that the effects of the present invention are not impaired, the photosensitive resin layer may further contain other additives such as a photopolymerizable monomer other than the above-described (meth)acrylate, an ultraviolet absorber, a dye, a pigment, an anti-foaming agent, and a fragrance, for the purpose of improving various properties.

### <Suitable aspect>

From the reason that the effects of the present invention are more excellent, the photosensitive layer preferably contains at least a binder, a (meth)acrylate having a molecular weight of 600 or less, a photopolymerization initiator, and a polymerization inhibitor, and satisfies the following requirements A-1 and B-1.

### (Requirement A-1)

Requirement A-1: in a case where a concentration of a (meth)acryloyl group of the (meth)acrylate having a molecular weight of 600 or less in the photosensitive layer is denoted by M, 0.4 ≤ M ≤ 2.0 is satisfied, in which a unit of the concentration is mol/kg.

The definition, specific examples, and suitable aspects of the (meth)acrylate are as described above.

In a case where the (meth)acrylate has only one (meth)acryloyl group, M is a concentration (mol/kg) of the (meth)acrylate in the photosensitive layer; and in a case where the (meth)acrylate has a plurality of (meth)acryloyl groups, M is a concentration (mol/kg) of the (meth)acrylate in the photosensitive layer multiplied by the number of (meth)acryloyl groups in one molecule of the (meth)acrylate.

### (Requirement A-2)

From the reason that the effects of the present invention are more excellent, it is preferable that M satisfies the following requirement A-2.

Requirement A-2: 0.65 ≤ M ≤ 1.0 is satisfied.

### (Requirement B-1)

Requirement B-1: in a case where a concentration of the photopolymerization initiator in the photosensitive layer is denoted by I and a concentration of the polymerization inhibitor in the photosensitive layer is denoted by K, 0.5 ≤ I/K ≤ 200 is satisfied, in which a unit of the concentration is mol/kg.

Specific examples and suitable aspects of the photopolymerization initiator and the polymerization inhibitor are as described above.

### (Requirement B-2)

From the reason that the effects of the present invention are more excellent, it is preferable that I and K satisfies the following requirement B-2.

Requirement B-2: 5 ≤ I/K < 100 is satisfied.

### <Thickness>

From the reason that the effects of the present invention are more excellent, a thickness of the photosensitive resin layer is preferably 0.2 to 6 mm, more preferably 0.5 to 3 mm, and still more preferably 1.0 to 2.0 mm.

### <Forming method>

A method of forming the photosensitive resin layer is not particularly limited, and examples thereof include a method of mixing the above-described respective components to prepare a composition (composition for a photosensitive resin layer), and applying the composition onto a base material or the like.

### [Heat-sensitive image forming layer]

The heat-sensitive image forming layer (infrared ablation layer) is a portion which can be removed by an infrared laser, and the unremoved portion shields (absorbs) ultraviolet light to mask the photosensitive resin layer below the unremoved portion from not being irradiated with the ultraviolet light.

Such an infrared ablation layer can be formed of a resin composition containing a binder polymer and an infrared absorbing substance.

### <Binder polymer>

Examples of the binder polymer contained in the resin composition include a rubber component and a resin component.

### (Rubber component)

The rubber component is not particularly limited as long as it is a rubber which does not hinder adhesiveness with the photosensitive resin layer.

Specific examples of the rubber include butadiene rubber (BR), acrylonitrile butadiene rubber (NBR), acrylic rubber, epichlorohydrin rubber, urethane rubber, isoprene rubber (IR), styrene isoprene rubber (SIR), styrene butadiene rubber (SBR), ethylene-propylene copolymer, and chlorinated polyethylene. These may be used alone or in combination of two or more.

### (Resin component)

The resin component is not particularly limited as long as it is a resin which does not hinder adhesiveness with the photosensitive resin layer.

Specific examples of the resin a (meth)acrylic resin, a polystyrene resin, a polyester resin, a polyamide resin, a polysulfone resin, a polyether sulfone resin, a polyimide resin, an acrylic resin, an acetal resin, an epoxy resin, and a polycarbonate resin, where one kind thereof may be used alone or two or more kinds thereof may be used in combination.

From the reason that the effects of the present invention are more excellent, the rubber component is preferably butadiene rubber (BR), acrylonitrile butadiene rubber (NBR), or styrene butadiene rubber (SBR), and more preferably acrylonitrile butadiene rubber (NBR).

In addition, from the reason that the effects of the present invention are more excellent, the resin component is preferably an acrylic resin or a methacrylic resin.

### <Infrared absorbing substance>

The infrared absorbing substance contained in the resin composition is not particularly limited as long as it is a substance which can absorb infrared rays and convert the infrared rays into heat.

Specific examples of the infrared absorbing substance include black pigments (for example, carbon black, aniline black, cyanine black, and the like), green pigments (for example, phthalocyanine, naphthalocyanine, and the like), rhodamine coloring agents, naphthoquinone-based coloring agents, polymethine dyes, diimmonium salts, azoimonium-based coloring agents, chalcogen-based coloring agents, carbon graphite, iron powder, diamine-based metal complexes, dithiol-based metal complexes, phenolthiol-based metal complexes, mercaptophenol-based metal complexes, aryl aluminum metal salts, crystal water-containing inorganic compounds, copper sulfate, metal oxides (for example, cobalt oxide, tungsten oxide, and the like), and metal powders (for example, bismuth, tin, tellurium, aluminum, and the like).

Among these, from the viewpoint of having an ultraviolet absorbing function and the like, carbon black, carbon graphite, or the like is preferable.

### <Additive>

The infrared ablation layer may contain various additives in addition to the binder polymer and the infrared absorbing substance described above.

Examples of such as additive include a surfactant, a plasticizer, an ultraviolet absorbing substance, a mold release agent, a dye, a pigment, an antifoaming agent, and a fragrance.

### <Forming method>

A method for forming the infrared ablation layer is not particularly limited, and examples thereof include a method of preparing a resin composition containing each of the above-described components and applying the resin composition to the photosensitive resin layer.

### <Thickness>

A thickness of the infrared ablation layer is preferably 0.1 to 6 µm and more preferably 0.5 to 3 µm.

### [Other layers]

The flexographic printing plate precursor may include a layer (other layers) other than the above-described layers. Examples of such a layer include a cover sheet (protective film) and a functional layer.

### <Cover sheet>

The flexographic printing plate precursor preferably includes a cover sheet on a side of the heat-sensitive image forming layer opposite to the photosensitive resin layer.

The cover sheet is not particularly limited, but is preferably a transparent polymer film and may be one layer alone or two or more layers laminated.

Here, the "transparent" means that a transmittance of visible light is 60% or more, preferably 80% or more and particularly preferably 90% or more.

Examples of a material of the polymer film include cellulose-based polymers; acrylic polymers having an acrylic acid ester polymer such as polymethyl methacrylate and a lactone ring-containing polymer; thermoplastic norbornene-based polymers; polycarbonate-based polymers; polyester-based polymers such as polyethylene terephthalate, polyethylene naphthalate, and a fluoropolyester polymer; styrene-based polymers such as polystyrene and an acrylonitrile-styrene copolymer (AS resin); polyolefin-based polymers such as polyethylene, polypropylene, an ethylene-propylene copolymer, and polybutadiene; vinyl chloride-based polymers; amide-based polymers such as nylon and aromatic polyamide; imide-based polymers; sulfone-based polymers; polyether sulfone-based polymers; polyether ether ketone-based polymers; polyphenylene sulfide-based polymers; vinylidene chloride-based polymers; vinyl alcohol-based polymers; vinyl butyral-based polymers; arylate-based polymers; polyoxymethylene-based polymers; epoxy-based polymers; and polymers obtained by mixing these polymers.

In addition, a surface (surface on which the heat-sensitive image forming layer is formed) of the cover sheet may be subjected to peeling treatment for suppressing adhesion of the heat-sensitive image forming layer and enhancing peelability of the cover sheet. Examples of such a peeling treatment include a method of applying a mold release agent to the surface of the cover sheet to form a peeling layer. Examples of the mold release agent include a silicone-based peeling agent and an alkyl-based peeling agent.

### (Thickness)

A thickness of the cover sheet is preferably 25 to 250 µm.

### <Functional layer>

The printing plate precursor according to the embodiment of the present invention may include an optional functional layer between the photosensitive resin layer and the heat-sensitive image forming layer.

The above-described functional layer is not particularly limited, and examples thereof include a layer (oxygen barrier layer) that blocks oxygen in the atmosphere, which may cause polymerization inhibition during ultraviolet (UV) exposure.

The oxygen barrier layer is preferably formed of a water-soluble polymer. Examples of the water-soluble polymer include polyvinyl alcohols, modified polyvinyl alcohols, polyvinylpyrrolidone, water-soluble cellulose derivatives, polyethylene glycol, poly(meth)acrylonitriles, and polyamides.

In addition, the functional layer may contain an additive within a range which does not adversely affect the performance.

Examples of the above-described additive include a plasticizer and various stabilizers.

In addition, in order to reduce the above-described defects of the functional layer, an additive such as an antifoaming agent and a leveling agent may be formulated as long as it does not adversely affect the performance.

### [Manufacturing method]

A method for manufacturing the flexographic printing plate precursor is not particularly limited, and examples thereof include a method of obtaining a laminate X consisting of heat-sensitive image forming layer/cover sheet by applying the composition for a heat-sensitive image forming layer onto the cover sheet and drying the cover sheet, sandwiching the composition for a photosensitive resin layer between the laminate X and an adhesive-coated surface of a support, and then heating and pressing the laminate to manufacture a flexographic printing plate in which the support, the photosensitive resin layer, the heat-sensitive image forming layer, and the cover sheet are laminated in this order.

### [Mask forming step]

The mask forming step is a step of forming an image on the heat-sensitive image forming layer to form a mask such that the image area satisfies the above-described requirement C, in which, on the heat-sensitive image forming layer, the image is formed by an FM screen in a region corresponding to the region of the halftone dots P described above and is formed by an AM screen in a region corresponding to the region of the halftone dots Q described above. By the mask forming step, a mask used in the exposure step described later is formed.

In the heat-sensitive image forming layer, in a case of being irradiated with an infrared laser, the action of the infrared absorbing pigment generates heat, which decomposes the thermally decomposable compound to remove, that is, to laser-ablate the heat-sensitive image forming layer.

Therefore, by selectively laser-ablating the heat-sensitive image forming layer based on the image data, it is possible to obtain a mask capable of forming a latent image on the photosensitive resin layer.

For the infrared laser irradiation, an infrared laser having an oscillation wavelength in a range of 750 nm to 3,000 nm is used.

Examples of such a laser include a solid-state laser such as a ruby laser, an Alexandrite laser, a perovskite laser, an Nd-YAG laser, and an emerald glass laser; a semiconductor laser such as InGaAsP, InGaAs, and GaAsAl; and a coloring agent laser such as a Rhodamine coloring agent.

In addition, a fiber laser which amplifies these light sources with a fiber can also be used.

Among these, from the reason that drawing accuracy is improved, it is preferable to use a fiber laser.

As described above, in the mask forming step, the image is formed by a frequency modulation (FM) screen on the heat-sensitive image forming layer in the region corresponding to the region of the halftone dots P. The FM screen is a method of forming an image by a density of irregularly arranged halftone dots having an substantially constant diameter.

In addition, the image is formed by an amplitude modulation (AM) screen in the region corresponding to the region of the halftone dots Q. The AM screen is a method of forming an image by a size (diameter) of halftone dots (regularly arranged halftone dots) having a certain screen ruling.

For example, in a case of manufacturing the printing plate having the image area of Fig. 2 described above, an image is formed by the FM screen such that the shading of the image area is formed by the halftone dots P having a substantially constant diameter (for example, 25 µm) in a region (region corresponding to the region A') corresponding to the region of the halftone dots P (region A) in the heat-sensitive image forming layer; and an image is formed by the AM screen such that the shading of the image area is formed by the halftone dots having the screen ruling α (for example, screen ruling of 175) in a region (region corresponding to the region B') corresponding to the region of the halftone dots Q (region B) in the heat-sensitive image forming layer.

### [Exposure step]

The exposure step is a step of imagewise exposing the photosensitive layer through the mask obtained in the above-described mask forming step, and by imagewise irradiating the photosensitive layer with ultraviolet rays, crosslinking and/or polymerization of regions irradiated with the ultraviolet rays can be induced to be cured.

Examples of the light source for the exposure include a fluorescent lamp and an LED-UV (ultraviolet light source using a light emitting diode), but from the reason that the effects of the present invention are more excellent, LED-UV is preferable.

### [Development step]

The development step is a step of performing development using a developer to form the image area and the like.

The developer used in the development step is not particularly limited, and known developer in the related art can be used. However, from the viewpoint of reducing the environmental load, it is preferable to use a developer containing 50% by mass or more of water (hereinafter, also abbreviated as "aqueous developer"). The developer may be an aqueous solution or a suspension (for example, an aqueous dispersion liquid).

In addition, a content of water contained in the aqueous developer is preferably 80% to 99.99% by mass and more preferably 90% to 99.9% by mass with respect to the total mass of the aqueous developer.

### [Rinse step]

From the reason that the effects of the present invention are more excellent, the manufacturing method according to the embodiment of the present invention preferably includes a rinsing step of, after the above-described development step, rinsing a surface of the image area and the like formed in the development step with water.

As a rinsing method in the rinse step, a method of washing with tap water, a method of spraying high pressure water, a method of rubbing the surface of the image area and the like with a brush using a known batch-type or transport-type brush-type washing machine as a developing machine for flexographic printing plates mainly in the presence of water, and the like may be used.

### [Back exposure step]

From the reason that the effects of the present invention are more excellent, the manufacturing method according to the embodiment of the present invention preferably includes a back exposure step of, before the above-described mask forming step or before the above-described exposure step, performing ultraviolet irradiation from the support side of the flexographic printing plate precursor.

### Examples

Hereinafter, the present invention will be described in more detail with reference to Examples, but the present invention is not limited thereto.

### [Preparation of composition for heat-sensitive image forming layer]

100 parts by mass of carbon black and 3 parts by mass of a plasticizer were added to 100 parts by mass of a binder polymer consisting of 50 parts by mass of an acrylic resin A (Hi-pearl M5000, Tg: 65°C, manufactured by Negami Chemical Industrial Co., Ltd.) and 50 parts by mass of NBR, and 812 parts by mass of methyl isobutyl ketone as a solvent was further added thereto, the mixture was mixed by stirring with blades. The obtained mixed solution was dispersed by a three-roll mill, and methyl isobutyl ketone was further added thereto so that the solid content was 15% by mass, thereby preparing a composition for a heat-sensitive image forming layer.

### [Preparation of composition for photosensitive layer]

A composition for a photosensitive layer, used in each example, was prepared as follows.

### [Examples 1, 8, and 9, and Comparative Examples 1 and 2]

62 parts by mass of a water-dispersible latex (Nipol LX111NF, water-dispersible latex of polybutadiene, solid content: 55%, manufactured by ZEON CORPORATION), 10 parts by mass of a telechelic polymer (BAC-45, manufactured by OSAKA ORGANIC CHEMICAL INDUSTRY LTD.; polybutadiene having acryloyloxy groups at both terminals, Mw = 10,000), 6 parts by mass of 1,9-nonanediol dimethacrylate (NK ESTER NOD-N, manufactured by Shin-Nakamura Chemical Co., Ltd.), and 6 parts by mass of tricyclodecane dimethanol dimethacrylate (NK ESTER DCP, manufactured Shin-Nakamura Chemical Co., Ltd.) were mixed with each other, and moisture was evaporated for 3 hours in a dryer heated to 60°C to obtain a mixture containing water-dispersible particles.

The mixture, 20 parts by mass of butadiene rubber (NF35R, manufactured by Asahi Kasei Co., Ltd.), 15 parts by mass of a plasticizer (Diana Process Oil PW-32, manufactured by Idemitsu Kosan Co., Ltd.), and 4.3 parts by mass of a surfactant (RAPISOL A-90, effective content: 90%, manufactured by NOF CORPORATION) were kneaded in a kneader set at 110°C for 45 minutes. Thereafter, 0.1 parts by mass of dibutylhydroxytoluene (BHT) as a thermal polymerization inhibitor and 4.5 parts by mass of Irgacure 651 as a photopolymerization initiator were put into the kneader, and the mixture was kneaded for 5 minutes to obtain a composition for a photosensitive layer.

### [Examples 2 to 7 and 10 to 13]

A composition for a photosensitive layer was prepared in the same manner as in Example 1, except that the amounts of the respective components were changed such that the contents (% by mass) of the respective components with respect to the total solid content were the values (% by mass) shown in Table 1.

In Example 7, carbinol-modified silicone oil (KF-6000) was blended.

### [Preparation of composition for oxygen barrier layer]

A composition for an oxygen barrier layer was prepared by mixing a low saponification degree polyvinyl alcohol (KH20, manufactured by NIHON GOSEI KAKO Co.,Ltd.), a plasticizer (SUNFLEX SE270, manufactured by SANYO CHEMICAL INDUSTRIES, Ltd.; aliphatic polyhydric alcohol-based polyether polyol, concentration of solid contents: 85%), and NBR latex (SX1503A, manufactured by ZEON CORPORATION, concentration of solid contents: 42%) at a mass ratio of 50/20/30.

### [Production of flexographic printing plate precursor]

A flexographic printing plate precursor used in each example was produced as follows.

That is, the composition for a heat-sensitive image forming layer described above was applied onto a PET film (cover sheet) having a thickness of 125 µm, which had been coated with a silicone-based mold release agent, using a bar coater such that a thickness of the coating film after drying was 1 µm, and dried at 120°C for 5 minutes to obtain a laminate X consisting of heat-sensitive image forming layer/cover sheet.

Next, the composition for a photosensitive layer described above was interposed between the above-described laminate X and a surface of a support, which had been formed by coating a surface of a PET film (base material) having a thickness of 125 µm with an adhesive, and the laminate was pressed with a press machine heated to 120°C such that a thickness of the photosensitive layer was 1.5 mm, thereby producing each flexographic printing plate precursor in which the support, the photosensitive layer, the heat-sensitive image forming layer, and the cover sheet were laminated in this order.

However, in Example 8, an oxygen barrier layer (thickness: 2.0 µm) was formed between the photosensitive layer and the heat-sensitive image forming layer using the above-described composition for an oxygen barrier layer. Therefore, the flexographic printing plate precursor of Example 8 was a flexographic printing plate precursor in which the support, the photosensitive layer, the oxygen barrier layer, the heat-sensitive image forming layer, and the cover sheet were laminated in this order.

### [Production of flexographic printing plate]

Each flexographic printing plate was produced as follows, using each of the obtained flexographic printing plate precursors.

### [Back exposure step]

Back exposure was performed by exposing a back surface of the flexographic printing plate precursor to an energy of 80 W for 10 seconds using the following ultraviolet exposure machine.

### [Mask forming step]

Next, the cover sheet was peeled off, and the heat-sensitive image forming layer was ablated using the following imaging machine to perform imaging.

As the image, a 0% to 100% gradation image having a width of 1 cm and a length of 10 cm was used.

More specifically, an image was formed as follows (4,000 dpi (dot per inch)) using a RIP software Automation Engine Pilot.

In a case where the above-described gradation image was assumed to be formed by halftone dots having a screen ruling of 175, a region where the diameter of the halftone dots was less than the value described in the column of "β" in Table 1 (hereinafter, also simply referred to as "β") was defined as a region A', and a region where the diameter of the halftone dots was equal to or more than β was defined as a region B'. In the heat-sensitive image forming layer, an image was formed by the FM screen such that the shading of the image area was formed by the irregularly arranged halftone dots P having a diameter of β in a region corresponding to the region A'. In addition, in the heat-sensitive image forming layer, an image was formed by the AM screen such that the shading of the image area was formed by the halftone dots Q having a screen ruling of 175 in a region corresponding to the region B'.

However, in Comparative Example 1, for all regions of the heat-sensitive image forming layer, an image was formed by the AM screen such that the shading of the image area was formed by the halftone dots Q having a screen ruling of 175. In addition, in Comparative Example 2, for all regions of the heat-sensitive image forming layer, an image was formed by the FM screen such that the shading of the image area was formed by the halftone dots P having a diameter of 24 µm.

### [Exposure step]

The main exposure was performed by exposing a front surface (reverse surface of the back surface) at 80 W for 360 seconds using the following ultraviolet exposure machine.

However, in Example 9, the main exposure was performed by exposing the front surface for 720 seconds under the conditions of 3 rotations at a UV illuminance of 200 mW/cm² using CDI Spark 2530 Inline (ultraviolet (LED-UV) exposure machine) (manufactured by Esko-Graphics BV.).

### [Development step]

Next, development was performed for 12 minutes using the following washing machine and washing solution.

### [Drying step]

Next, the obtained product was dried with hot air at 60°C until the moisture was removed.

### [Post-exposure step]

Next, the obtained product was exposed (post-exposed) for 180 seconds from the photosensitive layer side using the following ultraviolet exposure machine. In this manner, a flexographic printing plate having an image area was obtained.

### [Apparatus and the like]

· Imaging machine: CDI Spark 4835 Inline (manufactured by Esko-Graphics BV.)
· Ultraviolet exposure machine: Concept 302 ECDLF (product name) (manufactured by Glunz & Jensen)
· Washing machine: C-Touch 2530 Water Wash Plate Processor (manufactured by GS Trading Co., Ltd.)
· Washing solution: aqueous solution of FINISH POWER & PURE POWDER SP (manufactured by Reckitt Benckiser Japan Ltd.) (concentration: 0.5% by mass)

### [Image area]

The image area of the obtained flexographic printing plate was as follows.

### <Examples 1 to 13>

In the region X, the shading was formed by the irregularly arranged halftone dots P having a diameter of β.

In addition, in the region Y, the shading was formed by the irregularly arranged halftone dots P having a diameter of β, or by the halftone dots Q having a screen ruling of 175.

In addition, in the region Z, the shading was formed by the halftone dots Q having a screen ruling of 175.

The diameter of the halftone dots P was β, and the diameter of the halftone dots Pmin was also β. In addition, the diameter of the halftone dots Q was equal to or more than β. Therefore, the diameter of the halftone dots Pmin was equal to or less than the diameter of the halftone dots Q.

Here, as shown in Table 1, since β of all of Examples 1 to 13 was 17 µm or more and 45 µm or less, all of Examples 1 to 13 satisfied the above-described requirement C.

### <Comparative Example 1>

The shading was formed by the halftone dots Q having a screen ruling of 175 in all the regions. The diameter of halftone dots Qmin having the smallest diameter among the halftone dots Q was 2 µm.

In Comparative Example 1, since the shading of the region X was formed by the halftone dots Q, the above-described requirement C was not satisfied.

### <Comparative Example 2>

The shading was formed by the irregularly arranged halftone dots P having a diameter of 25 µm in all the regions.

In Comparative Example 2, since the shading of the above-described region Z was formed by the halftone dots P, the above-described requirement C was not satisfied.

### [Evaluation]

The obtained flexographic printing plate was evaluated as follows.

### [Printing durability]

The obtained flexographic printing plate was evaluated for UV ink resistance as follows.

A flexographic printing machine (manufactured by TAIYO KIKAI Ltd., TLF-270) was used as a printing machine. The obtained flexographic printing plate was attached to a plate cylinder (drum) through a cushion tape (manufactured by Lohmann), and installed in the printing machine. Thereafter, a kiss-touch (printing pressure at which the entire surface of the image started to be inked) was set to 0 (reference printing pressure), and from there, printing was performed at a printing speed of 150 m/min under the condition of pushing in 80 µm. A printed material used for the evaluation was sampled up to 25 km every 5 km under the above-described conditions. As the printed material, Aurora Coat 84.9 g/m² (manufactured by Nippon Paper Industries Co., Ltd.) was used. In addition, as an ink, UV flexo ink UV500J (manufactured by T&K TOKA Co., Ltd.) was used.

The number of chippings was measured in a portion of 0% to 30% in the printed material (a portion of 0% to 3 cm in the produced image having a width of 1 cm and a length of 10 cm). A printing distance in which 75 halftone dots were chipped among halftone dots landed on the printed material at the start was set as an end point, and a distance to the end point was evaluated according to the following standard.

The results are shown in Table 1 below. Practically, A to D are preferable, A to C are more preferable, A to B are still more preferable, and A is particularly preferable.
· A: 30 km or more
· B: 25 km or more and less than 30 km
· C: 20 km or more and less than 25 km
· D: less than 15 km and less than 20 km
· E: less than 15 km

### [Ink picking]

Printing was performed using the obtained flexographic printing plate, and the number of halftone dots printed on the printed material by being connected by the ink (the number of picking) was counted in a portion of 5% to 60% in the printed material (a portion of 0.5 cm to 6 cm from 0% in the produced image having a width of 1 cm and a length of 10 cm), and evaluated as follows.

The results are shown in Table 1 below. Practically, A to C are preferable, A or B is more preferable, and A is still more preferable.
· A: number of picking was 10 or less.
· B: number of picking was 11 or more and 20 or less.
· C: number of picking was 21 or more and 40 or less.
· D: number of picking was 41 or more.

**[Table 1]**

| | | Example | | | | | | | | | | | | | Comparative Example | |
|---|---|---|---|---|---|---|---|---|---|---|---|---|---|---|---|---|
| | | 1 | 2 | 3 | 4 | 5 | 6 | 7 | 8 | 9 | 10 | 11 | 12 | 13 | 1 | 2 |
| (Meth)acrylate | 1,9-Nonanediol dimethacrylate | 6 | 8 | 5 | 6 | 6 | 9 | 6 | 6 | 6 | 16 | 2 | 6 | 6 | 6 | 6 |
| | Tricyclodecane dimethanol diacrylate | 6 | 5 | 3 | 6 | 6 | 0 | 6 | 6 | 6 | 10 | 3 | 6 | 6 | 6 | 6 |
| Photopolymerization initiator | Irgacure 651 | 4.5 | 4.5 | 4.5 | 4.5 | 4.5 | 4.5 | 4.5 | 4.5 | 4.5 | 4.5 | 4.5 | 5 | 2.5 | 4.5 | 4.5 |
| Polymerization inhibitor | BHT | 0.1 | 0.1 | 0.1 | 0.035 | 0.8 | 0.1 | 0.1 | 0.1 | 0.1 | 0.1 | 0.1 | 0.02 | 5 | 0.1 | 0.1 |
| Silicone compound | Carbinol-modified silicone oil | 0 | 0 | 0 | 0 | 0 | 0 | 0.1 | 0 | 0 | 0 | 0 | 0 | 0 | 0 | 0 |
| Water-dispersible latex | Nipol LX111NF | 34.1 | 34.1 | 34.1 | 34.1 | 34.1 | 34.1 | 34.1 | 34.1 | 34.1 | 34.1 | 34.1 | 34.1 | 34.1 | 34.1 | 34.1 |
| Telechelic polymer | BAC-45 | 10 | 10 | 10 | 10 | 10 | 10 | 10 | 10 | 10 | 5 | 10 | 10 | 10 | 10 | 10 |
| Butadiene rubber | NF35R | 20 | 20 | 20 | 20 | 20 | 20 | 20 | 20 | 20 | 20 | 20 | 20 | 20 | 20 | 20 |
| Plasticizer | Diana Process Oil PW-32 | 15.0 | 14.0 | 19.0 | 15.1 | 14.3 | 18.0 | 14.9 | 15.0 | 15.0 | 6.0 | 22.0 | 14.6 | 12.1 | 15.0 | 15.0 |
| Surfactant | RAPISOLA-90 | 4.3 | 4.3 | 4.3 | 4.3 | 4.3 | 4.3 | 4.3 | 4.3 | 4.3 | 4.3 | 4.3 | 4.3 | 4.3 | 4.3 | 4.3 |
| Requirement A | M | 0.92 | 1.04 | 0.64 | 0.92 | 0.92 | 0.80 | 0.92 | 0.92 | 0.92 | 2.07 | 0.37 | 0.92 | 0.92 | 0.92 | 0.92 |
| Requirement B | I/K | 38.69 | 38.69 | 38.69 | 110.53 | 4.84 | 38.69 | 38.69 | 38.69 | 38.69 | 38.69 | 38.69 | 214.92 | 0.43 | 38.69 | 38.69 |
| Oxygen barrier layer | | N | N | N | N | N | N | N | Y | N | N | N | N | N | N | N |
| β [µm] | | 24 | 26 | 24 | 40 | 18 | 32 | 32 | 24 | 24 | 30 | 20 | 40 | 18 | Only AM | Only FM |
| Exposure method | | Fluorescent lamp | Fluorescent lamp | Fluorescent lamp | Fluorescent lamp | Fluorescent lamp | Fluorescent lamp | Fluorescent lamp | Fluorescent lamp | LED | Fluorescent lamp | Fluorescent lamp | Fluorescent lamp | Fluorescent lamp | Fluorescent lamp | Fluorescent lamp |
| Microhardness [MPa] | | 4.0 | 1.9 | 2.0 | 1.5 | 2.3 | 1.7 | 10.0 | 15.0 | 15.0 | 1.0 | 1.3 | 0.5 | 1.4 | - | - |
| Evaluation | Printing durability | B | C | C | C | C | C | A | A | A | D | D | D | D | E | B |
| | Ink picking | A | B | A | C | A | B | A | A | A | B | A | C | A | A | D |

In Table 1, the column of "M" indicates M of the above-described requirement A, and the column of "I/K" represents I/K of the above-described requirement B.

In addition, in Table 1, the column of "Microhardness" indicates the microhardness of the halftone dots P.

As can be seen from Table 1, in Examples 1 to 13 in which the image area satisfied the requirement C, all exhibited excellent printing durability and ink picking. Among these, in Examples 1 to 9 in which the photosensitive layer satisfied the requirement A-1 and the requirement B-1, the printing durability was more excellent.

From the comparison between Example 1, Example 3, Example 5, and Example 7 (comparison between aspects in which only the photosensitive layer was different), Examples 1 and 7 in which the photosensitive layer satisfied the requirement A-2 and the requirement B-2 exhibited more excellent printing durability. Among these, in Example 7 in which the photosensitive layer contained a silicone compound, the printing durability was further excellent.

In addition, from the comparison between Example 1 and Example 8 (comparison between aspects in which only the presence or absence of the oxygen barrier layer was different), Example 8 in which the flexographic printing plate precursor included an oxygen barrier layer exhibited more excellent printing durability.

In addition, from the comparison between Example 1 and Example 9 (comparison between aspects in which only the exposure method was different), Example 9 in which the LED-UV was used as the light source in the exposure step exhibited more excellent printing durability.

On the other hand, in Comparative Example 1 in which the image area did not satisfy the requirement C (the shading of the region X was formed by the halftone dots Q), the printing durability was insufficient.

In addition, in Comparative Example 2 in which the image area did not satisfy the requirement C (the shading of the region Z was formed by the halftone dots P), the ink picking was insufficient.

### Explanation of References

X': region X'
Y': region Y'
Y1': region Y1'
Y2': region Y2'
Z': region Z'
A': region A'
B': region B'
β: diameter of halftone dots as boundary between region Y1' and region Y2'
X: region X
Y: region Y
Y1: region Y1
Y2: region Y2
Z: region Z
A: region A
B: region B

## Claims

1. A flexographic printing plate comprising:
an image area,
wherein the image area satisfies the following requirement C,
the requirement C: assuming that a shading of an image expressed by the image area is formed by halftone dots having a screen ruling α, in a case where a region of the image area corresponding to a region X' where a diameter of the halftone dots is less than 17 µm is defined as a region X, a region of the image area corresponding to a region Y' where a diameter of the halftone dots is 17 µm or more and 45 µm or less is defined as a region Y, and a region of the image area corresponding to a region Z' where a diameter of the halftone dots is more than 45 µm is defined as a region Z,
in the region X, the shading is formed by irregularly arranged halftone dots P having a diameter of 17 µm or more and 45 µm or less,
in the region Y, the shading is formed by the irregularly arranged halftone dots P having a diameter of 17 µm or more and 45 µm or less, or by halftone dots Q having the screen ruling α, and
in the region Z, the shading is formed by the halftone dots Q having the screen ruling α,
provided that, among the halftone dots P, a diameter of halftone dots Pmin having a smallest diameter is equal to or less than a diameter of the halftone dots Q.

2. The flexographic printing plate according to claim 1,
wherein the flexographic printing plate is obtained from a flexographic printing plate precursor including a support and a photosensitive layer in this order,
the photosensitive layer contains at least a binder, a (meth)acrylate having a molecular weight of 600 or less, a photopolymerization initiator, and a polymerization inhibitor, and
the following requirements A-1 and B-1 are satisfied,
the requirement A-1: in a case where a concentration of a (meth)acryloyl group of the (meth)acrylate in the photosensitive layer is denoted by M, 0.4 ≤ M ≤ 2.0 is satisfied, in which a unit of the concentration is mol/kg,
the requirement B-1: in a case where a concentration of the photopolymerization initiator in the photosensitive layer is denoted by I and a concentration of the polymerization inhibitor in the photosensitive layer is denoted by K, 0.5 ≤ I/K ≤ 200 is satisfied, in which a unit of the concentration is mol/kg.

3. The flexographic printing plate according to claim 1,
wherein a microhardness of the halftone dots P is 1.5 MPa or more and 30 MPa or less.

4. The flexographic printing plate according to claim 2,
wherein the photosensitive layer satisfies the following requirement A-2,
the requirement A-2: 0.65 ≤ M ≤ 1.0 is satisfied.

5. The flexographic printing plate according to claim 2,
wherein the photosensitive layer satisfies the following requirement B-2,
the requirement B-2: 5 ≤ I/K ≤ 100 is satisfied.

6. The flexographic printing plate according to claim 2,
wherein the photosensitive layer contains two or more kinds of (meth)acrylates.

7. The flexographic printing plate according to claim 2,
wherein the photosensitive layer further contains a silicone compound.

8. The flexographic printing plate according to claim 2,
wherein the flexographic printing plate precursor further includes a heat-sensitive image forming layer, and the support, the photosensitive layer, and the heat-sensitive image forming layer are provided in this order, and
the flexographic printing plate precursor further includes an oxygen barrier layer between the photosensitive layer and the heat-sensitive image forming layer.

9. A method for manufacturing a flexographic printing plate, in which the flexographic printing plate is the flexographic printing plate according to any one of claims 1 to 8, and is obtained from a flexographic printing plate precursor including a support, a photosensitive layer, and a heat-sensitive image forming layer in this order, the method comprising:
a mask forming step of forming an image on the heat-sensitive image forming layer to form a mask such that the image area satisfies the requirement C, in which, on the heat-sensitive image forming layer, the image is formed by an FM screen in a region corresponding to the region of the halftone dots P and is formed by an AM screen in a region corresponding to the region of the halftone dots Q;
an exposure step of imagewise exposing the photosensitive layer of the flexographic printing plate precursor through the mask after the mask forming step; and
a development step of, after the exposure step, performing development using a developer to form the image area.

10. The method for manufacturing a flexographic printing plate according to claim 9,
wherein the exposure step is a step of performing the exposure using an LED-UV as a light source.
